# EUROPEAN PATENT APPLICATION

(11) **EP 1 196 019 A1**
(43) Date of publication of application: **10.04.2002**
(21) Application number: 01830622.5
(22) Date of filing: 03.10.2001
(51) Int. Cl.: H05K 9/00

(54) **Multilayer product for insulation against electromagnetic radiation and corresponding production method**

(30) Priority: 06.10.2000 IT FI000201
(71) Applicant: Industrie Biagioli S.p.a., 59100 Prato (IT)
(72) Inventor: Biagioli, Stefano, 59100 Prato (IT)
(74) Representative: Mannucci, Michele

(57) **Abstract**

Described herein is a multilayer product for providing insulation against electromagnetic radiation in building structures, as well as a method for the production thereof. The product comprises in combination: a first layer of non-woven fabric (5) containing metal fibres (6), a second layer of non-woven fabric (7), and an electrically conductive sheet (9) set between said first layer and said second layer of non-woven fabric.

## Description

### Technical field

The present invention regards a multilayer product for providing insulation in building structures of various kinds, for residential or industrial use or for any other use, in particular insulation against electromagnetic radiation.

The invention also regards a method for producing a multilayer product of the aforesaid type.

### Background of the invention

Modern technological development is characterized by an increasingly massive use of electromagnetic waves as a means for transmitting information. In particular, recent times have witnessed a boom in the area of so-called mobile telephony, which uses repeaters, including even very powerful ones, installed in densely inhabited centres, that emit electromagnetic radiation which may have a disturbing effect on people, and the effects of which on health have not yet been adequately assessed. Electromagnetic radiation is also generated by medium-voltage and high-voltage electrical products, as well as by electrical and electronic installations and equipment of various kinds, such as radar stations, radio and television transmitters and repeaters, and radio relay systems or transmission cells for cell phones.

In connection with electromagnetic radiation present in the environment, on account of its potentially harmful effect on health, often reference is made to a new form of pollution referred to as "electrosmog".

Consequently, there is increasingly felt the need for adequate protection from the aforementioned radiation, at least inside dwellings and other closed environments.

### Objects and summary of the invention

Object of the present invention is to provide a product for the creation of insulation from electromagnetic radiation, for use especially in building structures, which once laid in an appropriate way constitutes an effective barrier against a wide range of wavelengths of the said radiation.

Another object of the present invention is also to provide a product of the type referred to above which is economical to produce and simple and inexpensive to install.

A further object of the present invention is to provide a method for the production of a multilayer product of the type referred to above.

Basically, the multilayer product for providing insulation against electromagnetic radiation according to the invention comprises in combination: a first layer of non-woven fabric containing metal fibres, a second layer of non-woven fabric, and an electrically conductive sheet set between the first layer and the second layer of non-woven fabric.

The combination of the sheet made of electrically conductive material and the structure of metal fibres dispersed and intimately mixed with the textile fibres of the first layer of non-woven fabric, which forms a sort of Faraday shield, makes it possible to obtain a result in terms of abatement of electromagnetic radiation which is far superior to the one that could be achieved by using just an electrically conductive sheet or just a layer of non-woven fabric with a sufficient amount of conductive metal fibres dispersed therein.

With the multilayer product according to the invention it is possible to obtain an effect of shielding in the region of the 30 dB corresponding to a level of abatement of electromagnetic radiation of approximately 95%, in a very wide range, namely between approximately 8 MHz and approximately 10 GHz. On the other hand, the use of just a sheet of electrically conductive material does not enable levels of abatement of over 50% of the electromagnetic radiation in the range considered to be achieved. Instead, the combination of the two components enables an extremely high level of abatement of the electromagnetic radiation.

The use of two layers made of non-woven fabric makes it possible to bestow, on the multilayer product, an effect of thermal and acoustic insulation, in addition to the effect of electromagnetic insulation; consequently, with a product that has a very low cost and is easy to lay it is possible to obtain simultaneously both electromagnetic insulation on the one hand, and acoustic and thermal insulation on the other. Acoustic and thermal insulation can be currently obtained using traditional products for the building industry, which, however, do not provide any type of electromagnetic shielding.

According to a particularly advantageous and preferred embodiment of the present invention, the first layer and the second layer of non-woven fabric, with the electrically conductive sheet sandwiched between them, are joined together by entanglement and, more in particular and preferably, by means of a mechanical entanglement process, namely by needle treatment, of a type in itself known and consisting in causing a plurality of needles to penetrate the textile web orthogonally to the plane where the latter lies.

When a needle-treatment process is adopted, the electrically conductive sheet set between the two layers of non-woven fabric is pierced by the needles and, in order to obtain a greater resistance to tearing and to prevent the electrically conductive sheet, for example, an aluminium sheet, from getting torn during the needle-treatment operation, according to a particularly advantageous embodiment of the invention it is envisaged that the electrically conductive sheet is a combination of a metal sheet - such as aluminium - and a layer of plastic material, in particular, but not exclusively, polyethylene. This layer of plastic material prevents tearing of the metal substrate of which the electrically conductive sheet is made.

A high level of efficiency in terms of abatement of electromagnetic radiation is obtained when the electrically conductive sheet provided with the plastic layer that prevents tearing thereof is set with its non-plastic-coated surface in contact with the first layer of non-woven fabric. The needle treatment is then preferably carried out in such a way that the metal fibres, which are intimately mixed with the textile fibres forming the first layer of non-woven fabric, penetrate inside the holes that the needles make in the sheet of electrically conductive material. There are thus established points of electrical connection between the cage-like structure formed by the randomly distributed metal fibres in the first layer of non-woven fabric and the electrically conductive material.

On the other hand, the possibility is not excluded of joining the various components of the multilayer material using other techniques, possibly including hydro-entanglement.

Preferably, the two non-woven fabrics forming the first layer and the second layer are in turn obtained by consolidation of a fibre layer, preferably by means of a mechanical-type consolidation, i.e., by means of needle treatment. The use is not, however, excluded of other consolidation processes, for example by means of water, resins, air, or processes of the spun-bonded type, heat-based processes, and so forth.

In a particularly advantageous embodiment of the invention, the first layer of non-woven fabric comprises a weight percentage of metal fibre of between 0.5 wt% and 15 wt%, preferably between 2 wt% and 6 wt%, and more preferably between 3 wt% and 5 wt%. The metal fibre is preferably, but not exclusively, steel fibre, of the type normally used for making antistatic fabrics, yarns, or non-woven fabrics.

The remaining part of the first layer of non-woven fabric may consist of polyester fibres or other suitable fibres preferably of a synthetic type, possibly also consisting of different types of fibres mixed together. Similar fibres or mixtures of fibres can be used for making the second layer of non-woven fabric.

According to a further development of the present invention, a waterproofing sheet is combined with the multilayer product described above, in such a way that the multilayer product can be used also for waterproofing, for example for roofs. This application is particularly useful for buildings on which repeaters of mobile-telephony systems are installed, since with the laying of just a single product it is possible to achieve simultaneously thermal insulation, electromagnetic insulation, and waterproofing of the building.

The waterproofing sheet is preferably joined to the layer of non-woven fabric by bonding, for example using a resin of the hot-melt type. The application is preferably on the outer surface of the second layer of non-woven fabric, i.e., the layer without electrically conductive fibres.

Also the waterproofing sheet can be electrically conductive, and in a particularly advantageous embodiment of the invention it consists of a metallized plastic film, for example a polypropylene film vacuum-coated with aluminium or with another material, and possibly using other metallization techniques of an appropriate type.

Application by means of a bonding process, and preferably a spot-gluing process, following upon the needle-treatment process for joining together the layers of non-woven fabric and the electrically conductive sheet sandwiched between them, makes it possible to maintain the waterproofing sheet intact.

The first layer of non-woven fabric has a thickness of, for example, between 1 and 5 mm, preferably of between 2.5 and 3 mm, and in a particularly advantageous embodiment approximately 2.8 mm. It moreover has a weight per unit area of, for example, between 300 and 400 g/m², preferably between 360 and 420 g/m², and in a particular embodiment a weight per unit area of approximately 390 g/m².

The second layer of non-woven fabric may have, for example, a thickness of between 1 and 2.5 mm, preferably between 1.5 and 2.2 mm, and in particular in a possible embodiment approximately 1.9 mm. It may moreover have a weight per unit area of between 150 and 250 g/m², preferably between 180 and 220 g/m², whilst in a particularly advantageous embodiment it has a weight per unit area of approximately 200 g/m².

The electrically conductive sheet set between the two layers of non-woven fabric may be an aluminium film having a thickness in the region of 30 µm combined with a polyethylene film having a thickness in the region of 40 µm, even though the above values are not binding. The waterproofing sheet may be a polypropylene sheet having a thickness of roughly 70 µm, appropriately metallized with a deposition of aluminium or other suitable metal material.

According to a further aspect, the invention regards a method comprising the steps of: arranging an electrically conductive sheet between a first layer of non-woven fabric containing metal fibres and a second layer of non-woven fabric; and joining together the electrically conductive sheet and said first layer and second layer of non-woven fabric.

Joining is obtained, according to a preferred embodiment of the method according to the invention, by means of a needle-treatment process, namely mechanical entanglement. In order to increase in a particularly effective way the power of abatement of electromagnetic radiation of the product according to the invention, the method envisages that the mechanical needling is performed by getting the needles to penetrate from the side of the first layer of non-woven fabric, i.e., the side where the metal fibre is present. In this way, part of the metal fibres is drawn by the needles inside the holes that the latter make in the electrically conductive sheet set between the two layers of non-woven fabric. This generates points of contact between the structure of the electrically conductive metal fibres present in the first layer of non-woven fabric and the electrically conductive sheet set between the two layers of non-woven fabric.

Further advantageous embodiments and features of the product according to the invention and of the corresponding production method are specified in the attached dependent claims.

### Brief description of the drawings

A better understanding of the present invention will be provided by the ensuing description and by the attached drawings, which illustrate a non-limiting practical embodiment of the invention and in which:
Fig. 1 is an extremely schematic view of a plant for the production of a multilayer product according to the invention;
Fig. 2 shows, greatly enlarged and not in scale, a cross section of a portion of product; and
Fig. 3 shows, again very schematically and not in scale, a perspective view of a piece of multilayer product where a flap of the first layer of non-woven fabric has been detached from the underlying electrically conductive sheet.

### Detailed description of the preferred embodiment of the invention

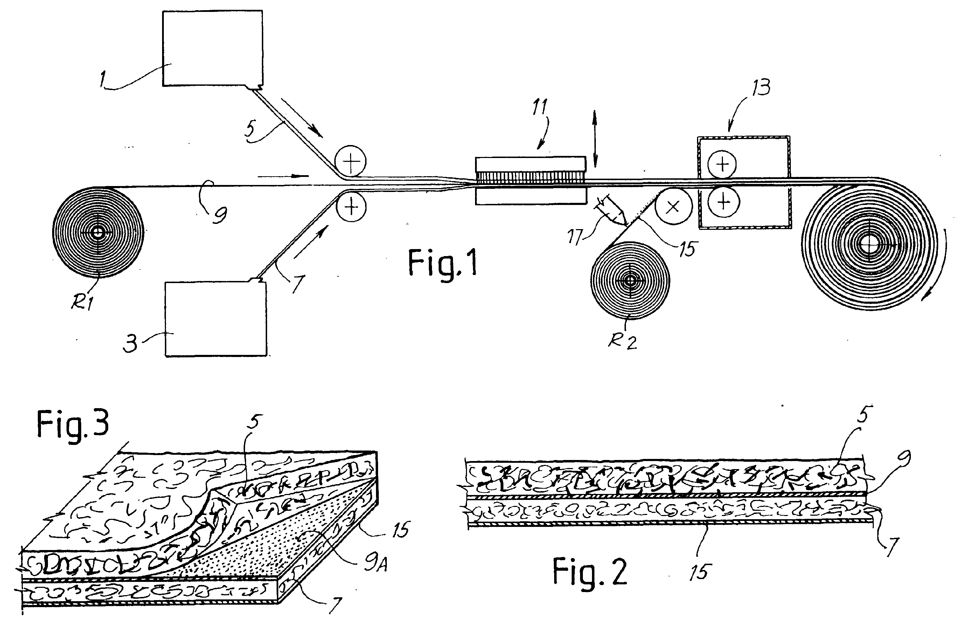

Fig.1 illustrates, in an extremely schematic way, a plant for the production of the product according to the invention. The various components of the plant may be of types in themselves known and will not be described in greater detail herein. The reference numbers 1 and 3 designate two line sections for the production of a first non-woven fabric and a second non-woven fabric, i.e., a web of consolidated fibres, for example consolidated by means of entanglement or needle treatment. The two layers of non-woven fabric, designated by 5 and 7, can also be produced separately in corresponding production lines, and can be wound onto reels from which they are then unwound to be fed to the plant in question.

Along the production line, between the first layer of non-woven fabric 5 and the second layer of non-woven fabric 7 there is set a sheet of electrically conductive material, designated by 9, fed from a roll R1.

The first layer of non-woven fabric 5 is a textile-based non-woven fabric, for example made of polyester fibre consolidated by entanglement or by any other suitable system. In the fibre mix there is also present a percentage of steel fibres 6, or fibres of another electrically conductive metal suitable for the purpose, for example aluminium or copper. The weight percentage of conductive fibre is between 0.5 wt% and 15 wt%, but preferably will be approximately 3-6 wt%, and particularly around 4 wt%.

The thickness and weight per unit area - and consequently the density - of the material have been specified previously.

The second layer of non-woven fabric 7 is made of textile fibres that can be similar to the ones of the first layer of non-woven fabric 5, for example in particular polyester, but the second layer 7 does not contain any conductive metal fibres. Possible values of weight per unit area and thickness, and hence of density, and preferred values of these parameters have been specified previously.

The electrically conductive sheet 9 consists of a combination of a plastic film and a metal film, the latter being, for example, an aluminium film typically with a thickness in the region of 10-50 µm and typically in the region of 25-35 µm, joined to a polyethylene layer having a thickness typically in the region of 20-60 µm and preferably in the region of 35-45 µm.

The three components 5, 7, 9 thus arranged side by side are sent on to a needle-treatment station, i.e., a mechanical-needling station, designated as a whole by 11. The needling operation is performed in such a way that the needles that penetrate the material to perform needle joining first of all encounter the first layer 5 of non-woven fabric, i.e., the layer containing the electrically conductive metal fibres. The needles traverse the electrically conductive sheet 9 and, in this movement, drag along with them at least some of the metal fibres contained in the layer of non-woven fabric 5, so that said metal fibres penetrate through the holes made in the electrically conductive sheet 9 and establish points of electrical contact.

Set downstream of the entanglement or needle-treatment station 11 is, according to the present embodiment, a station 13 in which a further waterproofing sheet, designated by 15 and fed, for example, from a roll or reel R2, is joined to the multilayer product made up of the components 5, 7 and 9. The waterproofing sheet 5 may consist, for example, of a polypropylene film with an aluminium coating, having a total thickness in the region of 40-80 µm, and typically in the region of 55-65 µm, even though different materials and thicknesses are not to be excluded. The station 13 is provided with means for applying pressure and heat which perform consolidation of the waterproofing sheet 15 on the bottom surface, i.e., the outer surface, of the second layer of non-woven fabric 7. On the waterproofing layer 15 there has been applied along the line (as represented by the nozzles 17 or equivalent means) an appropriate bonding agent of the hot-melt type, i.e., such as to become adhesive upon heating, or another appropriate bonding agent.

At output from the station 13 a product is obtained the structure of which is schematically represented in Fig. 2, namely a product made up of the first layer of non-woven fabric 5, joined by mechanical needling to the electrically conductive sheet 9 and to the second layer of non-woven fabric 7. The waterproofing sheet is applied on the outer surface of the latter by adhesion. For certain applications, the waterproofing sheet 15 may be omitted, especially when the multilayer product is to be used for insulation of vertical building structures, such as external walls or partition walls of buildings, whilst the waterproofing sheet will be used for insulating materials for roofings and floorings.

Fig. 3 very schematically illustrates the same product as Fig. 2, but with a flap of the first layer of non-woven fabric 5 raised from the underlying electrically conductive sheet 9 in order to show how the latter is provided with holes 9A caused by the mechanical needling used for joining the components 5, 7 and 9.

The table below shows the comparative data of the mean abatement values, expressed in dB for electromagnetic radiation with frequencies of from 30 to 1000 MHz, obtained with different types of materials. The tests were carried out according to the ASTM ES 7-83 Standard. The first column contains the characteristics of the products used, the second the mean abatement values, and the third remarks regarding the results of the measurements. The bottom row refers to a product according to the invention, characterized by the following parameters:
• first layer of needled (needle-treated) non-woven fabric consisting of 96 wt% polyester and 4 wt% steel fibre in intimate mix, weight 390 g/m², thickness 2.8 mm;
• second layer of needled (needle-treated) non-woven fabric consisting of 100% polyester fibre, weight 200 g/m², thickness 1.9 mm;
• interposed aluminium film, thickness 30 µm, joined with polyethylene film, thickness 40 µm; overall weight per unit area 130 g/m²;
• external waterproofing film made of aluminium-coated polypropylene, weight 15 g/m², thickness 60 µm.

| **Product** | **Mean value of abatement in dB between 30 and 1000 MHz according to ASTM ES 7-83 Standards** | **Notes** |
|---|---|---|
| polyester-staple felt 200 g/m² with 20 wt% steel fibre in mix | 2 | insufficient abatement of electromagnetic radiation |
| polyester felt needled with aluminium film | 18.9 | modest abatement of electromagnetic radiation |
| 100% steel-fibre felt | 31.4 | too costly; negligible thermal and acoustic insulation; difficult to lay |
| product according to the invention | 27 | good thermal and acoustic insulation; easy to lay; high abatement of electromagnetic radiation |

As emerges from the above comparative table, the result obtained with the product according to the invention is excellent, in so far as the product enables very high abatement values to be achieved, at the same time presenting excellent capacity for thermal and acoustic insulation.

It is understood that the drawings only illustrates a possible exemplification of the invention given purely to provide a practical demonstration of said invention, which may vary in its embodiments and arrangements without thereby departing from the scope of the underlying idea. The possible presence of reference numbers in the attached claims has the purpose of facilitating reading thereof in the light of the foregoing description and in no way limits the scope of protection represented by the claims.

## Claims

1. A multilayer product for providing insulation against electromagnetic radiation, in building structures, comprising in combination:
• a first layer of non-woven fabric (5) containing metal fibres (6);
• a second layer of non-woven fabric (7); and
• an electrically conductive sheet (9) set between said first layer and said second layer of non-woven fabric.

2. The multilayer product according to Claim 1, in which said first layer of non-woven fabric (5), said second layer of non-woven fabric (7), and said electrically conductive sheet (9) are joined together by mechanical entanglement or needle treatment.

3. The multilayer product according to Claim 2, in which said first layer and second layer of non-woven fabric and said electrically conductive sheet are entangled in such a way that at least some of the metal fibres (6) of said first layer of non-woven fabric pass through said electrically conductive sheet, which is pierced by the entanglement process that joins the layers together.

4. The multilayer product according to one or more of the foregoing claims, in which said first layer of non-woven fabric and said second layer of non-woven fabric are fibre layers consolidated by mechanical entanglement or needle treatment.

5. The multilayer product according to one or more of the foregoing claims, in which said first layer of non-woven fabric consists of polyester fibres in which said metal fibres are mixed.

6. The multilayer product according to Claim 5, in which said first layer of non-woven fabric comprises a weight percentage of metal fibre of between 0.5 wt% and 15 wt%, preferably between 2 wt% and 6 wt%, and more preferably between 3 wt% and 5 wt%.

7. The multilayer product according to one or more of the foregoing claims, in which said metal fibres are steel fibres.

8. The multilayer product according to one or more of the foregoing claims, in which said second layer of non-woven fabric consists of polyester fibres.

9. The multilayer product according to one or more of the foregoing claims, in which said electrically conductive sheet is a metal sheet with a plastic coating on at least one of its surfaces.

10. The multilayer product according to Claim 9, in which said metal sheet is made of aluminium.

11. The multilayer product according to Claim 9 or Claim 10, in which the surface with the plastic coating of said metal sheet is set facing the second layer of non-woven fabric, and the surface without any plastic coating is set facing said first layer of non-woven fabric.

12. The multilayer product according to one or more of the foregoing claims, in which a waterproofing sheet (15) is applied on the outer surface of one of said first layer and said second layer of non-woven fabric.

13. The multilayer product according to Claim 12, in which said waterproofing sheet (15) is applied to the outer surface of said second layer of non-woven fabric (7).

14. The multilayer product according to Claim 12 or 13, in which said waterproofing sheet is joined to the corresponding layer of non-woven fabric by bonding.

15. The multilayer product according to Claim 14, in which said waterproofing sheet is bonded by means of a hot-melt resin of by heat bonding.

16. The multilayer product according to one or more of Claims 12 to 15, in which said waterproofing sheet is electrically conductive.

17. The multilayer product according to Claim 16, in which said waterproofing sheet consists of a metal-coated plastic film.

18. The multilayer product according to Claim 17, in which said plastic film is metal-coated with aluminium.

19. The multilayer product according to one or more of the foregoing claims, in which said first layer of non-woven fabric has a thickness of between 1 and 5 mm, and preferably of between 2.5 and 3 mm, and a weight of between 300 and 400 g/m², and preferably of between 360 and 420 g/m².

20. The multilayer product according to one or more of the foregoing claims, in which said second layer of non-woven fabric has a thickness of between 1 and 2.5 mm, and preferably of between 1.5 and 2.2 mm, and a weight of between 150 and 250 g/m², and preferably of between 180 and 280 g/m².

21. A method for the production of a multilayer product for providing insulation against electromagnetic radiation in building structures, comprising the steps of:
• arranging an electrically conductive sheet (9) between a first layer of non-woven fabric (5) containing metal fibres (9) and a second layer of non-woven fabric (7); and
• joining together said electrically conductive sheet and said first layer and second layer of non-woven fabric.

22. The method according to Claim 21, in which said first layer of non-woven fabric, said second layer of non-woven fabric, and said electrically conductive sheet are joined together by mechanical entanglement or needle treatment.

23. The method according to Claim 22, in which by means of said mechanical entanglement there is caused passage of at least some of said metal fibres through said electrically conductive sheet, which is pierced by said entanglement.

24. The method according to one or more of Claims 21 to 23, in which a waterproofing sheet is applied to one of the outer surfaces of said first layer and second layer of non-woven fabric.

25. The method according to Claim 24, in which said waterproofing sheet is applied to the outer surface of the second layer of non-woven fabric.

26. The method according to Claim 24 or 25, in which said waterproofing sheet is applied by bonding.

27. The method according to one or more of Claims 21 to 26, in which said electrically conductive sheet is a metal sheet reinforced with a layer of plastic material to prevent tearing thereof during joining thereof to the layers of non-woven fabric.

28. The method according to one or more of Claims 21 to 27, comprising the steps of:
• forming a first fibre layer and consolidating said fibres to form said first layer of non-woven fabric;
• forming a second fibre layer and consolidating said fibres to form said second layer of non-woven fabric;
• arranging the electrically conductive sheet between said first layer and said second layer of non-woven fabric; and
• joining together said electrically conductive sheet and the two layers of non-woven fabric.

29. The method according to Claim 28, in which after said electrically conductive sheet has been joined to said first layer and said second layer of non-woven fabric, said waterproofing sheet is applied.
